# FASCICULE DE BREVET EUROPEEN

(11) **EP 1 660 946 B1**
(45) Date de publication et mention de la délivrance du brevet: **02.05.2007**
(21) Numéro de dépôt: 04787282.5
(22) Date de dépôt: 01.09.2004
(51) Int. Cl.: G03F 7/20, H05G 2/00

(54) **PROCEDE ET DISPOSITIF DE LITHOGRAPHIE PAR RAYONNEMENT DANS L'EXTREME ULTRAVIOLET**
VERFAHREN UND EINRICHTUNG ZUR LITHOGRAPHIE DURCH EXTREM-ULTRAVIOLETTSTRAHLUNG
METHOD AND DEVICE FOR LITHOGRAPHY BY EXTREME ULTRAVIOLET RADIATION

(30) Priorité: 05.09.2003 FR 0310547
(43) Date de publication de la demande: 31.05.2006
(73) Titulaire: COMMISSARIAT A L'ENERGIE ATOMIQUE, 75015 Paris (FR)
(72) Inventeur: CORMONT, Philippe, F-75013 Paris (FR); THRO, Pierre-Yves, F-91190 Gif-sur-Yvette (FR); VACHER, Charlie, F-69004 Lyon (FR)
(74) Mandataire: Hassine, Albert
(86) Numéro de dépôt international: PCT/FR2004/002226
(87) Numéro de publication internationale: WO 2005/029191

(56) Documents cités:
- FR-A- 2 814 599
- US-A- 4 504 964
- US-A- 6 038 279
- US-B1- 6 307 913
- PATENT ABSTRACTS OF JAPAN vol. 1996, no. 12, 26 décembre 1996 (1996-12-26) -& JP 08 213192 A (NIPPON TELEGR &TELEPH CORP <NTT>), 20 août 1996 (1996-08-20)

## Description

L'invention concerne la photolithographie par rayonnement dans l'extrême ultraviolet, notamment pour la fabrication de circuits intégrés.

Pour effectuer une photolithographie d'un objet tel qu'un futur circuit intégré, des zones choisies de l'objet, préalablement recouvertes d'une résine photosensible, sont exposées à une source de rayonnement dans le visible ou dans l'ultraviolet. Ce rayonnement insole les zones précitées et, de là, provoque des gravures locales dans l'objet.

En règle générale, la gravure est d'autant plus fine que la longueur d'onde du rayonnement est courte. Dans le document EP-1 222 842, on a proposé une source de rayonnement dans l'extrême ultraviolet (ou "*EUV*" ci-après) et son application à la photolithographie. La longueur d'onde du rayonnement s'étend d'environ 8 nanomètres à environ 25 nanomètres, permettant d'atteindre une finesse de gravure typiquement inférieure à une centaine de nanomètres. Le rayonnement est issu d'un plasma, siège d'une interaction entre un brouillard comportant des gouttelettes micrométriques de xénon et/ou d'eau et un faisceau laser. La source laser peut se présenter sous la forme d'un laser nanoseconde de type Nd:YAG. Elle excite un jet de particules issues d'une buse et formant ainsi le brouillard de gouttelettes précité.

On connaît en outre par la publication WO0232197 un rayonnement dans l'extrême ultraviolet résultant de l'excitation d'un jet liquide de xénon.

Dans un développement plus récent, décrit dans la publication FR-2 814 599, un rayonnement EUV est obtenu par l'interaction entre plusieurs faisceaux lasers et un jet de particules tel qu'un brouillard de xénon. En particulier, des sources lasers sont agencées pour émettre des tirs sensiblement en une même région du jet et sensiblement en même temps. Ainsi, on comprendra qu'en associant plusieurs sources lasers qui irradient sensiblement en même temps le jet de particules, on augmente la puissance crête du rayonnement que produit le plasma. La fréquence de tirs des lasers est de l'ordre de un à quelques dizaines de kHz. On entend ainsi par les termes *"sensiblement en même temps"* le fait qu'à chaque période de tir, par exemple toutes les 0,1 ms, un certain nombre d'impulsions élémentaires de lumière, chacune générée par un laser élémentaire, sont regroupées en un ensemble d'impulsions simultanées et/ou juxtaposées dans le temps appelées impulsions composites. Éventuellement cette juxtaposition peut constituer deux groupes d'impulsions à deux instants respectifs : un premier groupe pour amorcer le plasma et un deuxième groupe pour l'accroître, le décalage temporel entre ces deux groupes étant beaucoup plus petit que la période de récurrence des tirs. Il convient toutefois de remarquer que le décalage des impulsions élémentaires dans l'espace et dans le temps vise à adapter l'apport d'énergie aux besoins du plasma en fonction de son évolution temporelle, afin d'améliorer le bilan énergétique. Le dispositif décrit ne cherche aucunement à effectuer un réglage fin de la puissance lumineuse délivrée.

Depuis la publication de ce document FR-2 814 599, les attentes des industriels demandeurs d'un procédé de gravure dans l'extrême ultraviolet ont significativement évolué. Actuellement, ces industriels demandent, à l'instar du consortium néerlandais ASML:
- un processus de fabrication sensiblement continu, avec une vitesse de déplacement de la tranche de semiconducteur (ou *"wafer"*) à insoler de 400 mm/s,
- une cadence de récurrence des impulsions de rayonnement dans l'extrême ultraviolet de 10 kHz,
- en chaque point de la surface à insoler, une dose cumulée de rayonnement extrême ultraviolet de 5 mJ/cm², apportée par une succession de 50 impulsions,
- cette dose reçue ayant une distribution d'erreur devant être inférieure à 0,1 % de la consigne.

La dernière contrainte énoncée représente déjà en elle-même un défi technologique, sans solution dans l'art antérieur à la connaissance des inventeurs. En effet, certains phénomènes liés à la génération d'un plasma par illumination laser d'une cible, notamment lorsque celle-ci est constituée d'agrégats de xénon, sont encore mal connus ou, du moins, sont sujets à de nombreuses incertitudes. La position du jet de particules et les faisceaux lasers peuvent dériver temporellement en position, notamment à causes des variations importantes de température dans l'enceinte d'interaction. Le jet lui-même subit d'inévitables fluctuations.

Le document US 4 804 978 décrit un contrôle d'une dose d'énergie pour la photolithographie en utilisant des filtres atténuateurs montés sur une roue motorisée.
Cette solution ne permet pas toutefois un fonctionnement à cadence élevée car les tirs lasers sont interrompus pendant qu'un filtre est mis en place. Par ailleurs, un déplacement relatif continu de l'objet à graver par rapport à la source, est incompatible avec ce procédé qui impose au contraire une immobilité totale jusqu'à obtention de la dose cumulée d'énergie. Enfin, l'existence d'un nombre fini de filtres, correspondant à des valeurs discrètes d'atténuation, ne permet pas d'apporter la dose exacte d'énergie cumulée.

Le document US 6 034 978 décrit un autre type de contrôle de la stabilité de la source de rayonnement entre deux impulsions afin d'assurer la stabilité de la dose d'énergie fournie. Il est prévu en particulier un contrôle de la température du milieu gazeux qui est la source du rayonnement afin de contrôler la stabilité en intensité du rayonnement. Or, cette solution n'est pas transposable au dispositif décrit dans FR-2 814 599 puisque la source de rayonnement n'est pas un plasma comme dans FR-2 814 599, mais plutôt un laser gazeux. Un tel système de régulation de l'émission par refroidissement du laser gazeux par une circulation d'eau contrôlée est difficilement applicable dans le dispositif de FR-2 814 599 à jet de particules en brouillard. D'une part, un tel procédé ne peut prendre en compte les fluctuations du rendement de conversion entre énergie laser et énergie extrême ultraviolet, ce qui rend impossible son application à la génération de rayonnement extrême ultraviolet par interaction de lumière cohérente sur une cible plasmagène. D'autre part, il ne semble pas en l'état actuel de la technique qu'un tel laser puisse fournir l'énergie impulsionnelle intense et à haute cadence spécifiée par le consortium ASML.

En conclusion, à la connaissance des inventeurs, l'art antérieur n'offre ni ne suggère aucun autre procédé ou dispositif permettant une photogravure extrême ultraviolet qui d'une part soit effectivement en continu, c'est-à-dire sans que des étapes du processus autre que le déplacement de l'objet ne vienne ralentir le cadencement des impulsions de rayonnement extrême ultraviolet, et qui d'autre part permette un écart type sur la distribution de l'erreur sur les doses reçues de l'ordre de 0,1% ou inférieur. La présente invention vise à répondre à ce manque, et décrit un procédé permettant une photogravure extrême ultraviolet qui d'une part soit effectivement en continu, c'est-à-dire sans que des étapes du processus autre que le déplacement de l'objet ne vienne ralentir le cadencement des impulsions de rayonnement extrême ultraviolet, et qui d'autre part permette un écart type sur la distribution de l'erreur sur les doses reçues de l'ordre de 0,1% ou inférieur.

Un autre but de la présente invention vise un dispositif faisant application de ce procédé.

A cet effet, la présente invention prévoit d'abord un procédé de photolithographie par rayonnement dans l'extrême ultraviolet, dans lequel un objet ayant une surface plane, orthogonale au rayonnement, présentant une zone photosensible apte à se déplacer transversalement au rayonnement, reçoit un nombre prédéterminé N d'impulsions successives dans l'extrême ultraviolet (selon les spécifications ASML, N=50), en chaque point de la zone photosensible courante exposée au rayonnement. L'objet reçoit le rayonnement à travers une fenêtre d'irradiation de largeur choisie et qui est sensiblement immobile par rapport au rayonnement.

Les impulsions sont produites par l'impact, sur une cible apte à générer un plasma comportant au moins une raie d'émission dans l'extrême ultraviolet, d'au moins deux faisceaux de lumière cohérente issus de sources lasers pulsés, qui seront par la suite désignées *"laser"* tout court. Afin que le nombre de ces lasers reste raisonnable malgré l'importance de la puissance instantanée et de l'énergie requises pour que le plasma rayonne dans l'extrême ultraviolet, ces lasers, a priori de même puissance, ont chacun une puissance crête élevée, de l'ordre de plusieurs centaines de kW. Ils émettent des impulsions d'une énergie de quelques dizaines de mJ, et leur puissance moyenne est de l'ordre de plusieurs centaines de watts.

On appellera dans ce qui suit **"*quantum*"** la quantité d'énergie lumineuse générée à chaque tir par de tels lasers, semblables entre eux, ayant autant que possible une même durée Δt de tir laser (par exemple de l'ordre de 50 nanosecondes), et une même puissance crête de ces tirs (allant, selon la réalisation choisie, de plusieurs centaines de KW à plus d'un MW).

Par ailleurs, l'invention requiert que cette puissance crête reste inférieure à la valeur de seuil Pₛ qui produit dans un premier temps l'allumage du plasma, puis dans un second temps l'émission par ce plasma d'au moins une raie dans l'extrême ultraviolet.

En dessous de ce seuil Pₛ, l'allumage du plasma peut se produire, mais pas son rayonnement dans l'extrême ultraviolet.

Ces faisceaux lasers, lorsqu'ils frappent une même région de la cible précitée, génèrent un plasma possédant au moins une raie d'émission dans l'extrême ultraviolet. Le déplacement transversal de l'objet ayant une zone à insoler est choisi de manière qu'entre deux impulsions successives de rayonnement extrême ultraviolet, son amplitude soit une fraction 1/N de la largeur de la fenêtre d'irradiation selon la direction de ce déplacement.

Le procédé selon l'invention s'applique donc pour tout procédé de photolithographie dans lequel :
- l'objet à lithographier possède une surface plane, disposée orthogonalement au rayonnement lumineux, et présentant une zone photosensible, cet objet étant apte à se déplacer transversalement à ce rayonnement,
- le rayonnement effectuant la gravure comporte au moins une raie dans l'extrême ultraviolet, et est constitué de N impulsions courantes successives, dont l'énergie surfacique à travers une fenêtre d'irradiation est mesurée,
- ces impulsions de rayonnement sont produites par l'impact sur une cible appropriée d'au moins deux faisceaux laser issus de sources lasers pulsées choisies parmi une pluralité, émettant chacun à chaque déclenchement un quantum d'énergie de durée donnée, ces lasers étant focalisés au même endroit de la cible.

Par "*cible appropriée*", on entend une cible apte à émettre un plasma possédant au moins une raie d'émission dans l'extrême ultraviolet. Par "*pluralité de sources laser*" on entend une quantité suffisante pour produire l'irradiation nécessaire à une photogravure en N impulsions courantes.

Ce procédé est caractérisé en ce qu'il comporte les étapes itératives suivantes, énoncées pour une N^{ième} impulsion:
a) intégration de l'énergie surfacique de rayonnement extrême ultraviolet ayant traversé la fenêtre d'irradiation au cours des N - 1 dernières impulsions,
b) pendant l'intervalle de temps séparant deux impulsions successives de rayonnement, translation de l'objet photosensible d'une distance égale à u ne fraction 1/N de la largeur de la fenêtre d'irradiation selon l'axe de cette translation,
c) soustraction de l'intégrale obtenue à l'étape a) à la quantité d'énergie nécessaire au processus de photogravure,
d) détermination de la quantité d'énergie restant à fournir pour atteindre cette quantité d'énergie,
e) calcul du nombre de quanta d'impulsions restant à générer pour une N^{ième} impulsion,
f) détermination d'un nombre correspondant de sources lasers à allumer, puis choix de sources lasers en nombre égal à la partie entière de ce nombre,
g) déclenchement synchrone des lasers choisis à l'étape f),
et répétition ces étapes a) à g) pour le point courant suivant.

Dans le cas le plus général, le nombre de sources laser calculé à l'étape f) est fractionnaire, et la partie fractionnaire de ce nombre correspond à un apport d'énergie inférieur à un quantum.

Selon la réalisation préférentielle, dans laquelle le nombre de sources lasers calculé à l'étape f) est fractionnaire, la quantité d'énergie inférieure à un quantum, associée à cette partie fractionnaire du nombre de lasers, est apportée par une source laser capable de délivrer le quantum d'énergie commun aux autres sources lasers, et déclenchée avec un retard, inférieur à la durée Δt d'un quantum, par rapport à la date de déclenchement synchrone des autres sources lasers qui délivrent la partie entière du nombre de quantum de la même impulsion courante.

Dans ce cas en effet, l'impulsion apportant la partie fractionnaire d'un quantum dure au-delà de l'extinction des lasers choisis à l'étape f) ci-dessus, et.destinés à apporter la partie entière du nombre de lasers. Elle est alors seule, de sorte que la puissance instantanée globale devient inférieure au seuil Pₛ qui produit l'émission par le plasma d'au moins une raie dans l'extrême ultraviolet. Ainsi donc, la partie du quantum d'énergie postérieure à l'extinction des premiers lasers de cette même impulsion courante n'apporte plus aucune contribution au rayonnement extrême ultraviolet. Cela revient à réaliser, de fait, un quantum fractionnaire, mais ceci au moyen d'un laser identique aux lasers générant un quantum. Ce même laser peut, lors d'une autre impulsion courante, générer un quantum entier. Cela permet aussi une souplesse et une précision très importantes dans l'ajustement de la puissance laser.

Selon une seconde réalisation préférentielle, dans laquelle le nombre de sources lasers calculé à l'étape f) est fractionnaire, la quantité d'énergie inférieure à un quantum, associée à cette partie fractionnaire du nombre de lasers, est apportée par plusieurs sources laser capables de délivrer un même quantum d'énergie que les autres sources lasers, et dont :
- la première est déclenchée à un retard (1-k₁)Δt, (où 0<k₁<1) après l'instant du déclenchement des lasers synchrones représentant la partie entière du nombre de lasers,
- la seconde est déclenchée à un retard (1-k₂)Δt (où k₁<k₂<1) après l'instant du déclenchement des lasers synchrones représentant la partie entière du nombre de lasers,
- et ainsi de suite, la q^{ième} étant déclenchée à un retard (1-k_{q})Δt, (où 0<k_{q}<1) après l'instant du déclenchement des lasers synchrones représentant la partie entière du nombre de lasers, et
- en outre, la somme de ces retards est inférieure à la durée d'un quantum Δt.

Le coefficient k est préférentiellement choisi proportionnel à la partie fractionnaire du nombre de laser.

Selon une troisième réalisation préférentielle, dans laquelle le nombre de sources lasers calculé à l'étape f) est fractionnaire, la quantité d'énergie inférieure à un quantum, associée à cette partie fractionnaire du nombre de lasers, est apportée par une source laser capable de fournir une énergie inférieure à un quantum, et déclenchée avec un retard, inférieur à la durée Δt d'un quantum, par rapport à la date de déclenchement synchrone des autres sources lasers qui délivrent la partie entière du nombre de quantum de la même impulsion courante.

Selon une quatrième réalisation préférentielle, combinant les deux précédentes, dans laquelle le nombre de sources lasers calculé à l'étape f) est fractionnaire, la quantité d'énergie inférieure à un quantum, associée à cette partie fractionnaire du nombre de lasers, est apportée par plusieurs sources laser capables de délivrer une quantité d'énergie inférieure à un quantum, et dont :
- la première est déclenchée à un retard (1-k₁)Δt, (où 0<k₁<1) après l'instant du déclenchement des lasers synchrones représentant la partie entière du nombre de lasers,
- la seconde est déclenchée à un retard (1-k₂)Δt (où k₁<k₂<1) après l'instant du déclenchement des lasers synchrones représentant la partie entière du nombre de lasers,
- et ainsi de suite, la q^{ième} étant déclenchée à un retard (1-k_{q})Δt, (où 0<k_{q}<1) après l'instant du déclenchement des lasers synchrones représentant la partie entière du nombre de lasers, et
- en outre, la somme de ces retards est inférieure à la durée d'un quantum Δt.

La présente invention vise aussi un dispositif faisant application du procédé de l'invention. Le dispositif de photolithographie par rayonnement dans l'extrême ultraviolet comporte alors :
- une source de rayonnement dans l'extrême ultraviolet comportant au moins deux faisceaux lasers issus de sources lasers pulsées émettant chacune un quantum d'énergie de durée donnée au cours d'un tir laser, et capables d'exciter une même région d'une cible apte à émettre un plasma possédant au moins une raie d'émission dans l'extrême ultraviolet,
- une fenêtre d'irradiation de largeur choisie, interposée entre la source de rayonnement et l'objet, et immobile par rapport à la source de rayonnement,
- des moyens de déplacement transversal par rapport à la fenêtre, d'un objet à photolithographier ayant une surface plane, orthogonale au rayonnement, et présentant une zone photosensible, ledit déplacement étant choisi de manière qu'entre deux impulsions successives de rayonnement dans l'extrême ultraviolet, le déplacement transversal de l'objet par rapport à la fenêtre d'irradiation soit une fraction 1/N de la largeur de cette fenêtre selon la direction du déplacement, de sorte qu'une même bande dans ladite zone de l'objet soit exposée à un nombre prédéterminé N d'impulsions successives de rayonnement extrême ultraviolet.

Le dispositif au sens de l'invention comporte en outre :
- des moyens de mesure de la puissance crête du rayonnement à travers la fenêtre d'irradiation,
- des moyens de calcul, pour une N^{ième} impulsion courante à délivrer :
   * de la somme de l'énergie mesurée du rayonnement dans l'extrême ultraviolet des N-1 dernières impulsions, ce qui revient à dire de l'intégrale de la puissance crête d'irradiation sur la durée complète des N-1 dernières impulsions,
   * de la quantité d'énergie restant à fournir par une prochaine N^{ième} impulsion, en comparant ladite somme à une dose d'énergie totale prédéterminée nécessaire à la photogravure,
   * d'un nombre de quanta d'énergie que doivent fournir les sources lasers pour obtenir ladite quantité d'énergie de ladite N^{ième} impulsion, en tenant compte que les impulsions de lumière laser de puissance instantanée inférieure à la puissance de seuil ne contribueront pas à générer du rayonnement extrême ultraviolet,
- des moyens de sélection et de commande en synchronisme d'un nombre choisi de lasers en fonction du nombre de quanta calculé.
   Les moyens de déplacement de l'objet à photograver par rapport au rayonnement sont actifs pour déplacer ensuite l'objet d'un incrément équivalent à ladite fraction 1/N de la largeur de la fenêtre.

Selon la première variante où la partie fractionnaire du nombre de lasers est représentée par un quantum d'énergie en retard sur le déclenchement synchrone des précédents lasers, l'invention comporte en outre des moyens apte à générer de tels retards en fonction de la valeur de la partie fractionnaire du nombre de lasers, pour générer ladite N^{iéme} impulsion courante.

Selon une réalisation préférentielle, ladite cible est un jet directif de microgouttelettes de xénon en brouillard. En variante, cette cible peut être un jet liquide de xénon comme décrit dans la publication WO0232197 précitée.

Selon une réalisation préférentielle, cumulable avec la précédente, les tirs lasers sont issus de lasers solides impulsionnels fonctionnant en oscillateurs, et pompées par des diodes fonctionnant de façon continue.

Certains types de laser fonctionnent plus efficacement lorsque leur barreau, une fois chargé, est complètement déchargé avant la phase de pompage suivante. Pour satisfaire cette contrainte, le système de commande des lasers selon l'invention peut être prévu, selon une variante, pour que les quanta d'énergie non requis pour une impulsion courante soient déclenchés en dehors de cette impulsion, séparément, de manière à ce qu'ils ne dépassent jamais le seuil Pₛ.

D'autres caractéristiques et avantages de l'invention apparaîtront à l'examen de la description détaillée ci-après, et des dessins annexés sur lesquels :
- la figure 1 illustre schématiquement un dispositif pour la mise en oeuvre du procédé de photolithographie au sens de l'invention,
- la figure 2a représente schématiquement une variation du coefficient d'émission de la source de rayonnement EUV en fonction du nombre de sources lasers actives en même temps,
- la figure 2b représente schématiquement une variation de l'émissivité de la source EUV en fonction de l'énergie fournie par les tirs lasers,
- la figure 3a représente schématiquement la contribution des tirs lasers en fonction du temps, pour former des impulsions EUV d'énergies ajustées,
- la figure 3b représente schématiquement une impulsion EUV d'énergie ajustée, immédiatement suivie du déclenchement de quanta d'énergie en excès dont la puissance instantanée reste inférieure au seuil Ps,
- la figure 4 représente schématiquement une partie d'un bloc de commande pour la génération des tirs lasers,
- la figure 5 représente schématiquement des étapes d'un procédé au sens de l'invention,
- et les figures 6a à 6d représentent schématiquement la position de la fenêtre d'irradiation à des positions successives au cours de l'insolation de l'objet OBJ.

On indique que le procédé et le dispositif au sens de l'invention sont, de façon générale, appliqués à la photolithographie de circuits intégrés.

On réalise sur une surface de quelques mm² et sur une épaisseur de quelques microns un assemblage pouvant comporter plusieurs milliers de composants. Le matériau de départ est une tranche (ou "*wafer*") de silicium d'un diamètre d'une dizaine de cm. Ce disque subit plusieurs traitements chimiques (dépôt de couches minces, dopage...). Plusieurs circuits intégrés sont alors fabriqués sur la même tranche de silicium. L'un des traitements clés de la fabrication de circuits intégrés est la photolithographie.

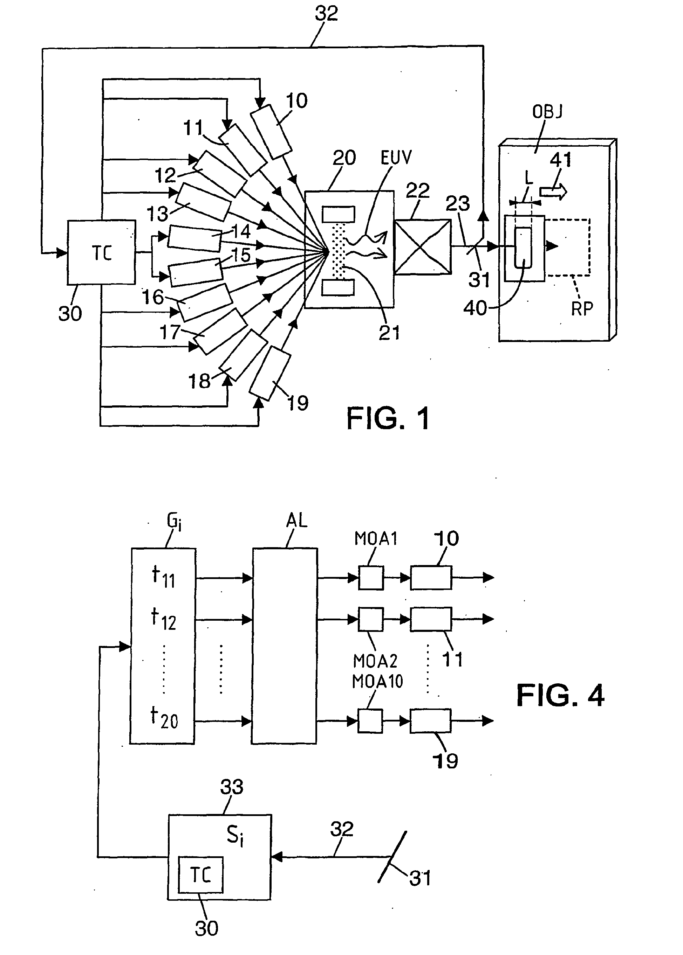

On se réfère à la figure 1 représentant un wafer OBJ auquel est appliqué un rayonnement dans l'EUV 23 (extrême ultraviolet) en vue de photolithographier le wafer. Plus particulièrement, l'objet OBJ à photolithographier présente une surface plane, orthogonale au rayonnement 23, et possède une zone photosensible enduite d'une une résine photosensible RP apte à se déplacer (flèche 41) transversalement à ce rayonnement 23.

Pour préparer cette phase, la plaque de silicium est chauffée au préalable à plus de 1000°C. La surface du wafer s'oxyde en formant une fine couche isolante d'oxyde de silicium. On applique ensuite, sur la zone devant être photosensible, une résine photosensible RP pour recouvrir localement la surface du wafer OBJ. Puis, la tranche de silicium OBJ est soumise au rayonnement 23, préférentiellement en utilisant un masque (non représenté) susceptible de représenter le motif de photolithogravure recherché. Cette étape dans le procédé de fabrication des circuits intégrés est dénommée "*insolation*". De la longueur d'onde de ce rayonnement dépend la précision obtenue de photolithographie et donc la taille du circuit intégré. Aujourd'hui, ces longueurs d'onde sont dans le visible ou l'ultraviolet. Afin d'obtenir une finesse de gravure de 40nm, une source EUV émettant un rayonnement de longueur d'onde 13,5 nm a été développée récemment, à une cadence de répétition préférée de 10kHz pour la photolithographie. L'émission EUV est obtenue par l'interaction entre un nombre préféré de 10 faisceaux lasers Nd:YAG pulsés, émettant à une cadence moyenne de 10kHz dans l'infrarouge (lasers solides) et un jet continu de Xénon. On obtient un plasma chaud émettant un rayonnement à une longueur d'onde de 13,5 nm.

Sur la figure 1, on a représenté des sources lasers référencées 10 à 19 qui sont capables d'exciter un jet de particules 21 circulant dans une chambre d'interaction 20. Préférentiellement, ce jet de particules 21 comporte un brouillard directif de microgouttelettes de xénon. Plus particulièrement, les lasers 10 à 19 sont capables d'émettre des tirs lasers focalisés en une même région du jet 21.

Les lasers actifs, en émettant chacun sur le jet de particules un tir d'une énergie de un quantum, l'excitent et tendent à y créer un plasma Si la contribution totale des quanta en énergie dépasse une valeur seuil Pₛ (correspondant au seuil d'émission de rayonnement extrême ultraviolet), le plasma d'interaction s'amorce puis la raie d'émission dans l'extrême ultraviolet apparaît pendant un temps correspondant approximativement au temps de l'impulsion laser dépassant le seuil Pₛ. Sur la figure 1, les flèches référencées EUV signalent l'occurrence une telle impulsion de rayonnement dans l'extrême ultraviolet. Elle se propage dans un large angle solide, et un dispositif optique de collection, non représenté, est utilisé recueillir ce rayonnement et le diriger vers l'objet à photograver.

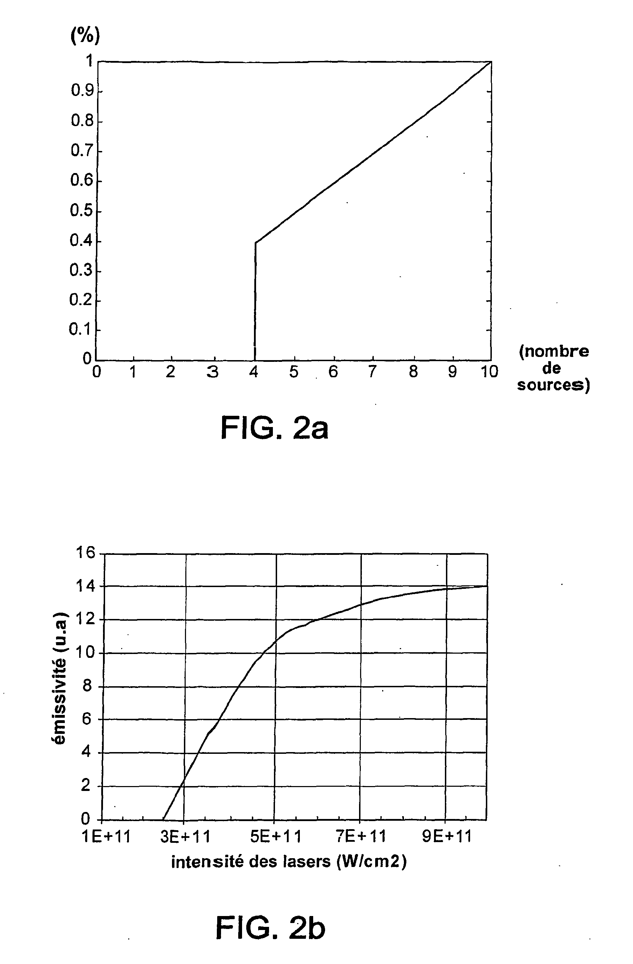

On a représenté schématiquement sur la figure 2a, à titre d'exemple, le coefficient d'émission de la source EUV (en pourcentage) en fonction du nombre de sources lasers actives qui tirent en même temps sur le jet de particules. Dans l'exemple décrit, quatre sources lasers suffisent pour amorcer le plasma. Dans la représentation plus exhaustive de la figure 2b de l'émissivité (en unités arbitraires) en fonction de l'énergie fournie par les tirs lasers, on indique qu'environ 2,5.10¹¹ W/cm² délivrés au jet de particules sont nécessaires, dans l'exemple décrit, pour chauffer le plasma.

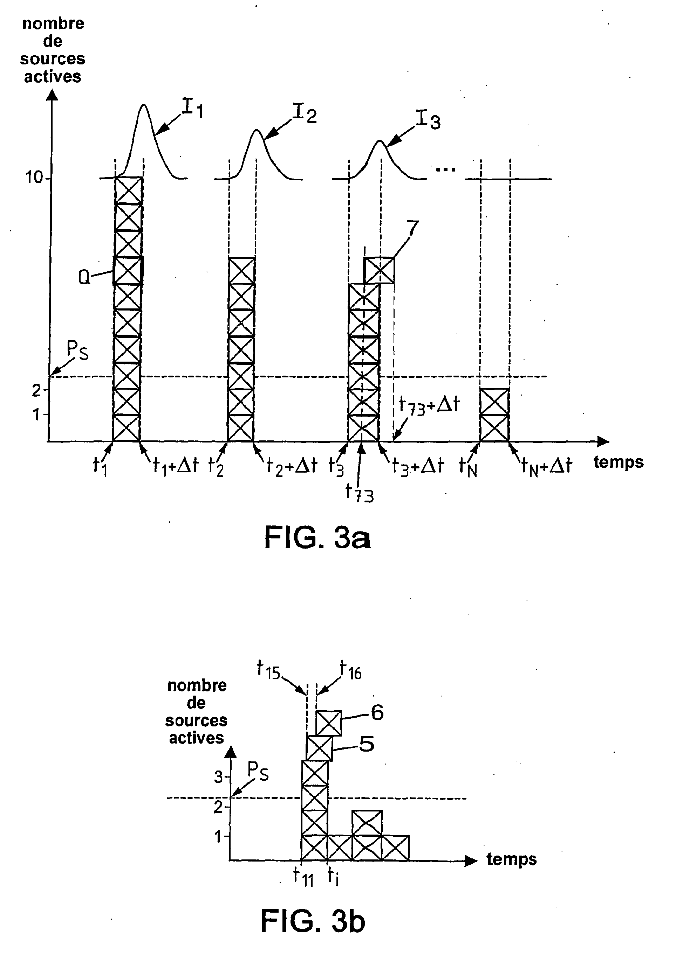

En se référant à nouveau à la figure 1, une table de commande 30 émet un signal de commande de chaque source laser 10 à 19, pour former ou non une impulsion dans l'EUV à un instant donné. Dans un mode de réalisation préféré, on commande un décalage temporel entre les tirs lasers nécessaires pour délivrer une impulsion à un instant donné, en particulier dans le but d'ajuster l'énergie de cette impulsion. On a représenté très schématiquement sur la figure 3a les impulsions émises I₁, I₂, I₃ en fonction du nombre de sources lasers actives et de la date des tirs lasers. Dans l'exemple décrit, toutes les sources lasers sont identiques ou, du moins, apportent une énergie identique au plasma pendant un tir laser. C'est la raison pour laquelle on a choisi de qualifier cette énergie de "*quantum*". Chaque source laser émet ici un tir d'une même durée Δt (typiquement de l'ordre de 40 nanosecondes pour un laser solide Nd:YAG) et d'une même puissance crête. Toutefois, une solution alternative consistant à choisir des sources lasers capables d'émettre des tirs de puissances crête différentes et/ou de durées Δt différentes est aussi envisagée pour affiner davantage l'énergie des impulsions émises. Dans ce cas, les quanta d'énergie que fournissent les sources lasers peuvent être différents d'une source laser à l'autre.

Ainsi, sur la figure 3a, chaque quantum Q d'énergie fournie à la source est représentée par un carré dans lequel se croisent deux diagonales. Pour délivrer une impulsion I₁ d'énergie maximale, toutes les dix sources lasers sont activées en même temps à la date t₁. Le plasma, réagissant à l'excitation des tirs lasers, délivre l'impulsion I₁ dans l'EUV dont le maximum d'énergie est atteint sensiblement à la date t₁+Δt. Pour délivrer une impulsion I₂ d'énergie plus faible que I₁, on a seulement recours à sept sources lasers dans l'exemple représenté. On comprendra ainsi que l'énergie de l'impulsion délivrée dans l'EUV est proportionnelle à l'empilement de quanta Q, donc au nombre de sources lasers actives en même temps. Dans une réalisation particulièrement avantageuse, pour délivrer une impulsion I₃ dont l'énergie ne correspond pas à un nombre entier de quanta Q, on choisit de décaler temporellement le tir d'une ou plusieurs sources lasers. Ainsi, dans l'exemple représenté sur la figure 3a, pour délivrer la troisième impulsion I₃, la septième source laser est activée à un instant t₇₃, décalé d'une durée inférieure à Δt par rapport à un même instant t₃ des autres tirs. Ainsi, le quantum portant la référence 7 sur la figure 3a est retardé d'une fraction de la durée spécifique Δt, par rapport aux autres quanta sous-jacents. Dans l'exemple représenté, la partie de gauche du quantum 7 (qui contribue, avec les autres quanta, au rayonnement) permet d'apporter sensiblement une moitié de quantum en énergie au plasma pour délivrer une impulsion, tandis que la partie de droite apporte un demi quantum qui est insuffisant pour entretenir le plasma de réaction et n'intervient donc pas dans l'énergie du rayonnement dans l'EUV. La période de récurrence des impulsions I₁, I₂, I₃ est de l'ordre de 0,1 milliseconde. On comprendra qu'une valeur typique de l'ordre de quelques dizaines de nanosecondes pour la durée Δt d'un tir laser est bien inférieure à la période des impulsions EUV. Ainsi, même si l'on commande un décalage temporel entre les tirs lasers d'une même salve, globalement, ces tirs ont lieu répétitivement à des dates sensiblement récurrentes et définissant une période de récurrence des impulsions EUV. Le décalage temporel entre tirs d'une même salve ne perturbe donc en rien la fréquence d'émission des impulsions.

On a représenté sur la figure 3a, à titre purement illustratif, un empilement de deux quanta à une même date de tir t_{N}. Pour simplifier le raisonnement, on supposera dans que la puissance instantanée d'un quantum est un peu inférieure à la moitié du seuil Pₛ. Ainsi sur cette figure, l'énergie apportée l'empilement à la date t_{N} est insuffisante pour amorcer le plasma à cette date t_{N}. En réalité, il nous faut généralement entre un et deux quanta pour atteindre ce seuil Pₛ.

On indique que dans la réalisation décrite ici, les sources lasers doivent tirer répétitivement pour vider l'énergie stockée dans le barreau laser. Ainsi, en se référant à la figure 3b, les dix lasers 10 à 19 peuvent tirer avec un décalage temporel entre les tirs, en dépassant à peine le seuil d'énergie nécessaire (correspondant sur la figure à plus de quatre quanta Q, mais en pratique à un peu plus de la puissance instantanée d'un quantum) pour amorcer le plasma et générer une impulsion spécifiquement dans l'EUV, à l'instant tᵢ. Avantageusement, on peut procéder ainsi pour faire tirer tous les lasers sans atteindre pour autant l'énergie maximale de l'impulsion I₁ décrite ci-avant. Ainsi, les tirs décalés par rapport à la date tᵢ ne contribuent pas à l'énergie utile de la source. Pour les tirs suivant cette date tᵢ, on indique que le décalage temporel peut être moins précis. En effet, pour créer le plasma et émettre l'énergie dans la bande spectrale désirée (dans l'EUV), il faut atteindre le seuil d'amorçage précité. Ainsi, on choisit avantageusement des lasers tels que l'énergie d'un seul laser ne crée pas de plasma ou crée un plasma qui n'émet pas dans la bande spectrale désirée.

Plus particulièrement, en se référant à la figure 3b, on constate que l'on peut ajuster, autant que souhaité, la contribution énergétique des tirs lasers à l'émission d'une impulsion EUV. En particulier, on peut commander un décalage temporel progressif des tirs référencés 5 et 6 pour générer une impulsion, la somme de ces décalages restant inférieur à la durée des tirs Δt.

Ainsi, le tir laser référencé 5 a lieu à un instant (1-k₁)Δt (avec 0<k₁<1) après l'instant t₁₁ d'allumage des lasers précédents et le tir laser référencé 6 a lieu à un instant (1-k₂)Δt (avec k₁<k₂<1) après l'instant t₁₁ d'allumage des lasers précédents. Ainsi, un mode de réalisation pour générer un "*quantum fractionnaire*" (quantité d'énergie fournie au plasma inférieure à un quantum et correspondant ainsi à une "*partie fractionnaire du nombre de lasers*"), on déclenche :
- la première source laser à un retard (1-k₁)Δt, (où 0<k₁<1) après l'instant du déclenchement des lasers synchrones représentant une partie entière du nombre de lasers,
- une seconde source laser à un retard (1-k₂)Δt (où k₁<k₂<1) après l'instant du déclenchement des lasers synchrones représentant la partie entière du nombre de lasers,
- et ainsi de suite, la q^{ième} source laser étant déclenchée à un retard (1-k_{q})Δt, (où 0<k_{q}<1) après l'instant du déclenchement des lasers synchrones représentant la partie entière du nombre de lasers, comme représenté schématiquement sur la figure 3b.
   Toutefois, la somme de ces retards reste inférieure à la durée d'un quantum Δt.
   Ce mode de réalisation peut être prévu pour de mêmes quanta que délivrent les lasers, ou encore pour des quanta qui diffèrent par exemple par leur puissance crête, que pourraient délivrer différents lasers, comme indiqué précédemment.

On indique qu'un instant de tir laser peut être commandé avec une précision supérieure à quelques nanosecondes. Ainsi, avec une durée de tir de l'ordre de 40 nanosecondes, il est possible de commander au moins une dizaine de décalages temporels différents, pour un tir laser à effectuer. On peut ainsi atteindre des fractions de quantum sensiblement de l'ordre d'un dixième de quantum, dans l'état actuel de la technique.

En bref, on commande ici le déclenchement :
- d'au moins un premier tir laser à un instant prédéterminé t₁₁ (quatre tirs lasers dans l'exemple représenté sur la figure 3b), et
- d'un ou plusieurs tirs lasers successifs à des instants respectifs t₁₅, t₁₆ choisis pour ajuster l'énergie d'une impulsion dans l'extrême ultraviolet à émettre, ces instants respectifs étant répartis dans un intervalle de temps inférieur à la durée des tirs Δt.

Comme l'énergie d'une impulsion émise par le plasma dépend de manière générale de la puissance crête de la somme des tirs lasers, on montre ainsi qu'il est possible de faire varier l'énergie de cette source-plasma en décalant temporellement les tirs lasers. Avantageusement, on peut faire varier très rapidement l'énergie émise par la source et ainsi commander indépendamment l'énergie de chaque impulsion lumineuse pour une source fonctionnant à une cadence de répétition pouvant aller jusqu'à plusieurs dizaines de kHz. L'avantage de cette solution est aussi qu'elle ne perturbe pas l'équilibre thermique de la source et qu'elle ne dérègle pas l'ensemble de la source. On a en effet observé que la source revient immédiatement à son état initial invariablement en fonction du nombre de tirs lasers simultanés. Ainsi, la source peut par exemple fonctionner à 80% de son énergie maximale et, le tir suivant, fonctionner à 100% de son énergie maximale. Dans l'exemple décrit, la fréquence moyenne des tirs lasers et, de là, la fréquence F des impulsions émises, sont de l'ordre de 10 kHz.

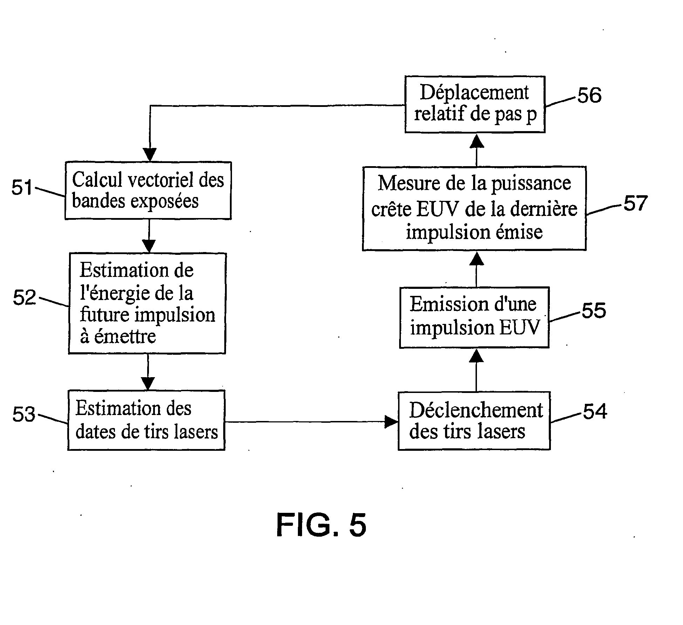

Un autre intérêt que procure l'utilisation d'un décalage temporel des tirs lasers consiste en ce que de tels décalages peuvent facilement être commandés. En effet, préférentiellement, le déclenchement de chaque tir laser s'effectue en utilisant un modulateur acousto-optique. En se référant à la figure 4, les modulateurs acousto-optiques MOA1 à MOA10, chacun associés à une source laser 10 à 19, sont commandés par une alimentation radiofréquence AL (opérant par exemple à 24 MHz à une puissance par exemple de 100 W). Cette fréquence de 24 MHz est en particulier bien supérieure à la cadence des tirs à 10 kHz (au moins d'un facteur de l'ordre de mille). Le déclenchement de l'impulsion des lasers Nd :YAG s'effectue en diminuant rapidement les pertes dans la cavité laser grâce à l'utilisation d'un tel modulateur acousto-optique associé. Un générateur d'impulsion GI envoie les dates de tirs t₁₁ à t₂₀ de chaque source laser à cette alimentation radiofréquence AL qui déclenche les tirs lasers aux instants demandés t₁₁ à t₂₀, pour déclencher une impulsion à un temps t₁. On comprendra ainsi que ces instants t₁₁ à t₂₀ sont estimés par la table de commande 30 de la figure 1.

En se référant à nouveau à la figure 1, des moyens de collimation et de focalisation 22 collectent le rayonnement issu de la chambre d'interaction 21, en format un faisceau 23 irradiant dans l'EUV le wafer OBJ à travers une fenêtre d'irradiation, 40, qui sera dorénavant appelée *"fenêtre"* tout court. En fait, ce faisceau est formé d'une succession d'impulsions I₁ à I_{N}. Avantageusement, on crée un déplacement relatif (flèche 41) du wafer OBJ par rapport à la fenêtre 40 et au faisceau 23. Ce déplacement 41 est préférentiellement d'un pas p qui est fonction de la largeur L de la fenêtre 40 (prise dans le sens du déplacement 41). Plus particulièrement, cette largeur L et le pas de déplacement p sont liés par la relation L=N.p, où N est le nombre prédéterminé d'expositions d'une même région du wafer OBJ au rayonnement EUV. Par ailleurs, la vitesse V de déplacement relatif 41 est telle que l'on parcourt un pas p en un temps correspondant à la période T de récurrence des impulsions EUV. Ainsi, la vitesse V est donnée par la relation V=p.F, où F est la fréquence des impulsions dans l'EUV. Chaque région dont la largeur correspond au pas p, recevant le rayonnement à travers la fenêtre 40, est bien insolée N fois, où N est le nombre prédéterminé précité. Dans une réalisation préférée, ce nombre N est de 50.

Plus précisément, dans une réalisation pratiquement imposée par les constructeurs de circuits intégrés, le procédé se déroule comme suit. La source EUV émet un rayonnement pulsé, typiquement à une fréquence de 10 kHz comme indiqué ci-avant, ce qui correspond à une impulsion toutes les 0,1 ms. Le rayonnement émis est ensuite collecté dans une direction (flèche 23 de la figure 1), puis dirigé au travers de la fenêtre 40 sur un masque (non représenté) du circuit à lithographier. Ce masque est imagé sur la tranche de silicium OBJ avec un grandissement de 0,25, de telle sorte que la dimension de l'image de la fenêtre sur le silicium soit de 26mmx2mm. En fonction de la vitesse de déplacement du masque et de la fenêtre 40, chaque bande sur la tranche de silicium de largeur correspondant à un pas p de déplacement de la fenêtre reçoit une certaine dose d'énergie. Cette dose totale d'énergie Wₜₒₜ est par exemple fixée à 5 mJ/cm². Pour atteindre cette énergie avec une source par exemple de 115 W à 10 kHz, chaque bande de la zone exposée devra recevoir une dose de 50 impulsions. La vitesse de déplacement de l'image de la fenêtre 40 sur la tranche de silicium OBJ est alors adaptée de sorte que lors du déplacement (préférentiellement continu) de la tranche de silicium, chaque bande est exposée à 50 impulsions. En conséquence, la largeur de la fenêtre 40 au niveau de la tranche de silicium correspond à 50 fois le pas p de déplacement de la tranche entre deux impulsions successives.

La tranche de silicium OBJ se déplaçant continûment par rapport à la source EUV et à la fenêtre 40, on assure la reproduction d'un motif de gravure complet. Ce déplacement, considéré comme continu en terme de processus, peut en réalité être indifféremment réalisé par un moteur pas à pas ou par un moteur effectivement continu. Dans ce dernier cas, comme les impulsions EUV sont très brèves, les déplacements de l'objet peuvent être considérés comme pratiquement nuls pendant la durée d'une impulsion EUV. Par contre, entre deux impulsions lumineuses, la tranche de silicium s'est déplacée d'une certaine distance correspondant au pas p précité. La dose d'énergie nécessaire pour l'insolation correspond dans l'exemple décrit à 50 impulsions dans l'EUV. L'écart-type de la distribution des doses doit être inférieur à 0,1%, ce qui correspond en bruit tir à tir en boucle ouverte à un écart type de 1 %. En raison des nombreuses incertitudes liées à la source EUV, cette contrainte de 1% de bruit tir à tir peut difficilement être assurée. Le contrôle de la dose reçue nécessite alors un asservissement en boucle fermée qui doit assurer cette contrainte tout en permettant une tolérance plus importante sur le bruit tir à tir. On appelle ici *"bruit tir à tir*" la fluctuation non contrôlée de l'énergie des impulsions émises.

Dans l'exemple décrit, on choisit préférentiellement les sources lasers de sorte que, si W_{MAX} correspond à l'énergie maximale d'une impulsion I₁ atteinte avec les dix tirs lasers simultanés, la dose totale d'énergie Wₜₒₜ que reçoit chaque région exposée est telle que Wₜₒₜ = 40 W_{MAX}, en gardant à l'esprit que cette dose totale Wₜₒₜ doit être atteinte à partir de 50 impulsions émises. On comprendra que la régulation de l'énergie des impulsions émises, à partir d'un décalage temporel des tirs lasers, permet notamment d'augmenter la tolérance du système au bruit *"tir à tir*", tout en assurant la stabilité de la dose d'énergie de la source.

On décrit ci-après cette régulation, préférentiellement basée sur un asservissement en boucle fermée.

Avant de parvenir sur la tranche de silicium OBJ, une partie du rayonnement 23 dans l'EUV est déviée sans atténuation vers un capteur 31 mesurant l'éclairement surfacique produit par une impulsion courante. Il peut s'agir d'une photodiode ou d'une caméra CCD. Avantageusement, le temps de réponse d'un tel capteur 31 est suffisamment rapide pour pouvoir acquérir des mesures à une fréquence au moins égale à 10 kHz. La mesure est communiquée ensuite à un système informatique intégrant la table de commande 30 (asservissement représenté par la flèche 32 de la figure 1). Pour simplifier le dessin de la figure 1, on a représenté le capteur 31 entre la source EUV et la fenêtre 40. En pratique, on prévoit plutôt de disposer ce capteur 31 après la fenêtre 40 dans le chemin du rayonnement 23 (pratiquement sur le wafer OBJ) de manière à ce que la mesure de la puissance crête EUV que reçoit effectivement le wafer OBJ soit la plus exacte possible.

Le système informatique 33 de la figure 4 assure plusieurs fonctions. Il est constitué d'une architecture matérielle classique. Il peut s'agir d'un microcontrôleur intégrant une mémoire, un processeur, une horloge, ou autres, ou encore d'un microprocesseur intégrant des cartes d'acquisitions entrée/sortie et permettant d'implémenter différentes fonctions. Compte tenu de la contrainte temporelle très forte consistant à mesurer la puissance crête EUV toutes les 0,1 ms, le calcul de la commande à appliquer, son application et le cheminement des informations doivent être exécutés en temps réel. Les commandes des dates de tirs t₁₀ à t₂₀ sont donc programmées et exécutées dans un environnement temps réel. Le processeur SI équipant le système informatique 33 est bien entendu de génération récente, capable d'exécuter toutes ces fonctions à une fréquence supérieure à la fréquence des impulsions EUV émises. Plus particulièrement, le capteur 31 (rapide en acquisition) et le système informatique 33, pour mener ces calculs, peuvent opérer conjointement pendant une période inférieure à une période de récurrence des impulsions EUV.

On se réfère maintenant à la figure 5 pour décrire les étapes successives de la régulation en boucle.

Après avoir émis une ou plusieurs impulsions vers le wafer OBJ, on calcule, à l'étape 51, "*l'état des bandes exposées",* c'est-à-dire les doses respectives qu'ont reçu jusqu'à présent les bandes de la zone en cours d'exposition au rayonnement EUV, en tenant compte de la mesure de la puissance crête EUV de la dernière impulsion émise (mesurée à l'étape 57). On construit ainsi un vecteur "*état*" contenant 50 composantes représentant l'état des 50 bandes venant d'être exposées. A chaque tir, les composantes du vecteur sont décalées pour une mise à jour telle que la composante associée à la bande exposée pour la dernière fois sorte du vecteur, tandis qu'entre une nouvelle composante associée à une bande qui va être exposée pour la première fois. Ce décalage est effectué pour prendre en compte le déplacement de la zone exposée du wafer OBJ, cette zone s'étant déplacée entre deux tirs.

A l'étape 52, on calcule, à partir d'une dose associée à une future bande sortante, l'énergie qu'il faudrait fournir à cette bande exposée pour la dernière fois à la prochaine impulsion EUV pour parvenir à la dose requise Wₜₒₜ. Cette énergie d'impulsion EUV est ensuite convertie en contribution de quanta d'énergie fournis par les sources lasers, en tenant compte du taux de conversion de l'énergie entre les tirs lasers et l'énergie EUV. On affine l'énergie de la future impulsion à délivrer en décalant temporellement les dates d'impulsion des tirs lasers, comme décrit ci-avant. A l'étape 53, on estime alors les dates appropriées des futurs tirs lasers. En ne superposant temporellement qu'une partie des quanta d'énergie fournie par les tirs, on peut alors obtenir une discrétisation très fine dans la commande de l'énergie EUV que l'on souhaite attribuer à la future impulsion. A l'étape 54, on déclenche les tirs lasers aux dates estimées à l'étape 53, ce qui génère, à l'étape 55, une impulsion EUV d'énergie choisie. Le procédé se poursuit en mesurant, à l'étape 57, la puissance crête EUV effective de l'impulsion émise à l'étape 55 et par le déplacement relatif d'un pas p, à l'étape 56, du wafer par rapport à la fenêtre et à la source de rayonnement EUV. Sur cette figure 5, on a donc représenté, à gauche de cette figure, les étapes de calcul menées par le système informatique 33.

Ainsi, dans ce mode de réalisation, la régulation proprement dite s'effectue préférentiellement pour la dernière impulsion à émettre en une bande courante de la zone du wafer OBJ exposée au rayonnement.

Sur les figures 6a à 6d, on a représenté par des hachures la zone photosensible créée par le dépôt d'un film de résine photosensible RP sur la surface du wafer OBJ.

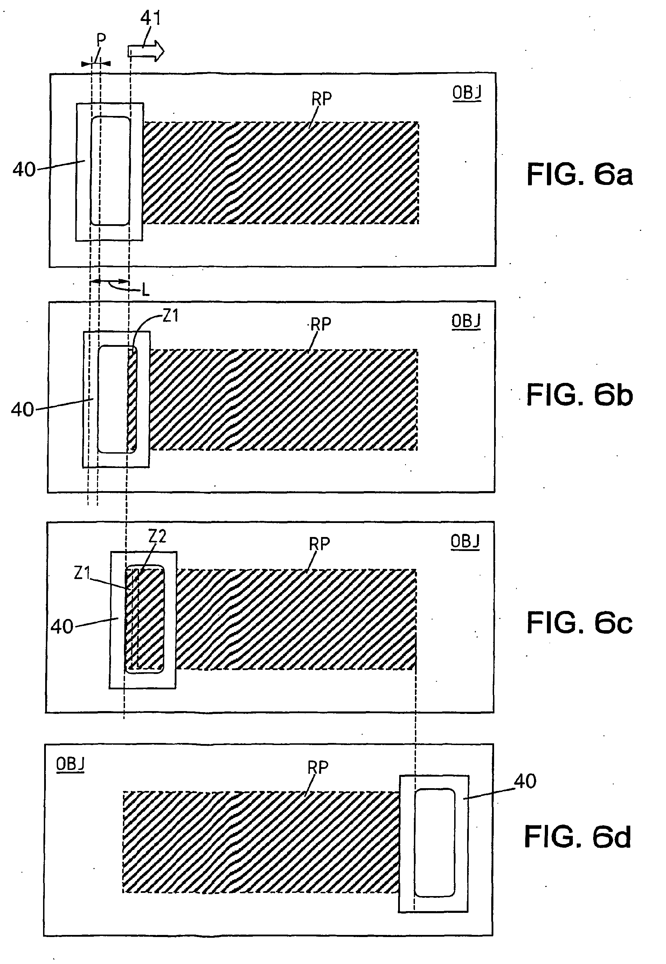

La figure 6a représente la position de la fenêtre 40 à l'instant auquel commence le procédé d'insolation. On déplace alors la fenêtre 40 d'un incrément de position p correspondant à la largeur L de la fenêtre divisée par le nombre N d'impulsions à délivrer en une même bande de la zone exposée au rayonnement, ce qui correspond à la position de la fenêtre représentée sur la figure 6b. On envoie une première impulsion EUV dans cette configuration de la figure 6b. La puissance crête EUV est mesurée pendant cette première impulsion émise, puis intégrée sur la durée de l'impulsion, tandis que la fenêtre 40 continue à se déplacer relativement au wafer OBJ du pas p, et ce, conformément au procédé de régulation décrit ci-avant en référence à la figure 5. Dans une réalisation préférée et dans une configuration intermédiaire entre les figures 6b et 6c où la zone à insoler du wafer OBJ située sous la fente d'insolation est plus étroite que cette fenêtre, on estime l'énergie de l'impulsion à émettre en soustrayant à l'énergie Wₜₒₜ à fournir pour insoler la surface photosensible courante la somme des énergies mesurée au cours des n impulsions successives précédentes, puis en divisant le résultat de cette soustraction par N-n (où N=50 dans l'exemple décrit et n est bien entendu inférieur à N). On comprendra ainsi que l'on incrémente le nombre n après chaque mesure de la puissance crête EUV d'une impulsion délivrée, puis le calcul de son intégrale donnant l'énergie effectivement reçue. Pour ajuster l'énergie des impulsions émises, on utilisera avantageusement des salves composites de tirs lasers du type représenté sur la figure 3b, avec des décalages temporels successifs des tirs 5,6 restant inférieurs à la durée Δt des tirs.

Lorsque la zone à insoler de l'objet, située sous la fenêtre d'irradiation, est plus large que la largeur de la fenêtre (configuration de la figure 6c), on estime l'énergie exacte restant à fournir pour que la tranche (ou *"bande"* comme désignée précédemment) de la zone à insoler subissant sa dernière irradiation obtienne la quantité totale d'énergie nécessaire à sa photogravure.

On a représenté à titre illustratif sur la figure 6c la position de la fenêtre 40 dans laquelle elle permet maintenant une irradiation pleine de la région photosensible du wafer OBJ. La bande Z1 qui était irradiée en premier sur la figure 6 b reçoit maintenant sa dernière (cinquantième) impulsion, régulée selon le procédé décrit ci-avant, tandis que la bande Z2 immédiatement adjacente (à droite sur la figure 6c) reçoit sa 49^{ième} impulsion. Lorsque la fenêtre 40 s'est déplacée encore d'un pas p, c'est cette bande Z2 immédiatement adjacente qui reçoit alors la cinquantième impulsion, d'énergie régulée en fonction de la dose d'énergie qu'elle a reçu précédemment, en vue d'atteindre la dose totale d'énergie précitée et notée Wₜₒₜ. Ainsi, on comprendra, de façon générale, que la première impulsion parmi les N impulsions (ici N=50) que doit recevoir une n^{ième} bande courante en cours d'irradiation correspond, en fait, à une n^{ième} impulsion depuis le début du procédé de photogravure.
Comme le montre la figure 6d, on poursuit le procédé d'insolation jusqu'à atteindre le bord de la région photosensible (à droite de cette figure 6d).

Ainsi, le début du procédé d'insolation peut se résumer comme suit:
a0) on positionne l'objet photosensible à lithographier sous la fenêtre, de manière à ce que seule soit exposée une tranche de zone à insoler ayant une largeur égale à ladite fraction 1/N de largeur de fenêtre,
a1) on sélectionne une partie au moins des sources lasers en vue d'exciter la cible génératrice de plasma, et déclencher une impulsion courante vers la zone à insoler,
a2) on mesure la puissance crête de l'impulsion courante de rayonnement extrême ultraviolet effectivement fournie à la zone à insoler de l'objet, et on calcule son intégrale sur la durée de l'impulsion,
a3) on déplace l'objet par rapport à la fenêtre, d'un incrément de position égal à une fraction 1/N de la largeur de fenêtre,
a4) répéter les étapes a1) à a3) tant que la zone à insoler de l'objet, située sous la fenêtre, est plus étroite que la fenêtre, en délivrant des impulsions d'énergies estimées en soustrayant à l'énergie Wₜₒₜ à fournir pour photograver l'objet la somme des énergies mesurées au cours de n passages successifs par l'étape a2), puis en divisant le résultat de la soustraction par N-n, où n est un entier inférieur au nombre prédéterminé d'impulsions N,
a5) lorsque la zone à insoler de l'objet, située sous la fenêtre, atteint la largeur de la fenêtre, on estime l'énergie exacte restant à fournir pour que la tranche de la zone à photograver recevant sa dernière impulsion obtienne la quantité totale d'énergie Wₜₒₜ pour sa photogravure.

De manière plus générale, des tests ont montré que l'utilisation d'un asservissement du type ci-avant assure une stabilité de dose de 0,1 % d'écart type, tout en autorisant un bruit tir à tir ayant un écart type pouvant aller jusqu'à 4% lorsqu'une commande fine des décalages temporels des tirs lasers est utilisée comme décrit ci-avant.

L'invention est définie par les revendications.

## Revendications

1. Procédé de photolithographie par rayonnement extrême ultraviolet, dans lequel :
- le rayonnement (23) effectuant la gravure comporte au moins une raie dans l'extrême ultraviolet, et est constitué de N impulsions courantes successives, dont l'énergie surfacique à travers une fenêtre d'irradiation (40) est mesurée,
- ces impulsions de rayonnement sont produites par l'impact sur une cible (21) apte à émettre un plasma possédant une raie d'émission dans l'extrême ultraviolet d'au moins deux faisceaux laser issus de sources lasers pulsées (10-19) choisies parmi une pluralité, émettant chacune à chaque déclenchement un quantum (Q) d'énergie de durée donnée (Δt), ces sources lasers étant focalisées au même endroit de la cible,
- un objet (OBJ) à lithographier possède une surface plane, disposée orthogonalement au rayonnement lumineux, et présentant une zone photosensible (PR), cet objet étant apte à se déplacer (41) transversalement à ce rayonnement (23), ledit déplacement étant choisi de manière qu'entre deux impulsion successives de rayonnement dans l'extrême ultraviolet le déplacement transversal de l'objet (OBJ) par rapport à la fenêtre soit une fraction I/N de la largeur de la fenêtre d'irradiation selon la direction du déplacement, de sorte qu'une même bande (Z1,Z2) de ladite zone de l'objet soit exposée à un nombre prédeterminé N d'impulsions successives dans l'extrême ultraviolet, ce procédé comportant les étapes itératives suivantes, énoncées pour la N^{ième} impulsion d'une bande (Z1,Z2) donnée:
a) intégration de l'énergie surfacique de rayonnement extrême ultraviolet ayant traversé la fenêtre d'irradiation au cours des N - 1 dernières impulsions,
b) pendant l'intervalle de temps séparant deux impulsions successives de rayonnement, translation de l'objet photosensible d'une distance égale à une fraction 1/N de la largeur (L) de la fenêtre d'irradiation selon l'axe de cette translation,
c) soustraction de l'intégrale obtenue à l'étape a) à la quantité d'énergie (Wₜₒₜ) nécessaire au processus de photogravure,
d) détermination de la quantité d'énergie restant à fournir pour atteindre cette quantité d'énergie (Wₜₒₜ),
e) calcul du nombre de quanta d'impulsions restant à générer pour une N^{ième} impulsion,
f) détermination d'un nombre correspondant de sources lasers à allumer, puis choix de sources lasers en nombre égal à la partie entière de ce nombre,
g) déclenchement synchrone des lasers choisis à l'étape f),
et répétition ces étapes a) à g) pour la bande suivante.

2. Procédé selon la revendication 1, dans lequel, le nombre de sources lasers calculé à l'étape f) est fractionnaire, et la quantité d'énergie inférieure à un quantum, associée à cette partie fractionnaire du nombre de lasers, est apportée par une source laser capable de délivrer le quantum d'énergie commun aux autres sources lasers, et déclenchée avec un retard, inférieur à la durée (Δt) d'un quantum, par rapport à la date de déclenchement synchrone des autres sources lasers qui délivrent la partie entière du nombre de quantum de la même impulsion courante.

3. Procédé selon la revendication 1, dans lequel le nombre de sources lasers calculé à l'étape f) est fractionnaire, la quantité d'énergie inférieure à un quanta, associée à cette partie fractionnaire du nombre de lasers, est apportée par une source laser capable de fournir une énergie inférieure à un quantum, et déclenchée avec un retard, inférieur à la durée (Δt) d'un quantum, par rapport à la date de déclenchement synchrone des autres sources lasers qui délivrent la partie entière du nombre de quantum de la même impulsion courante.

4. Procédé selon l'une des revendications 2 ou 3, dans lequel le nombre de sources lasers calculé à l'étape f) est fractionnaire, et la quantité d'énergie inférieure à un quanta, associée à cette partie fractionnaire du nombre de lasers, est apportée par plusieurs sources laser dont :
- la première est déclenchée à un retard (1-k₁)Δt, (où 0<k₁<1) après l'instant du déclenchement des lasers synchrones représentant la partie entière du nombre de lasers,
- la seconde est déclenchée à un retard (1-k₂)Δt (où k₁<k₂<1) après l'instant du déclenchement des lasers synchrones représentant la partie entière du nombre de lasers,
- et ainsi de suite, la q^{ième} étant déclenchée à un retard (1-k_{q})Δt, (où 0<k_{q}<1) après l'instant du déclenchement des lasers synchrones représentant la partie entière du nombre de lasers, et
- en outre, la somme de ces retards est inférieure à la durée d'un quantum Δt.

5. Procédé selon l'une des revendications 2 à 4, **caractérisé en ce que** l'on commande le déclenchement:
- d'au moins un premier tir laser à un instant prédéterminé (t₁₁), et
- d'un ou plusieurs tirs lasers successifs à des instants respectifs choisis pour ajuster l'énergie d'une impulsion dans l'extrême ultraviolet à émettre, ces instants respectifs étant répartis dans un intervalle de temps inférieur à ladite durée des tirs (Δt).

6. Procédé selon l'une des revendications précédentes, **caractérisé en ce que** l'on commande les sources lasers pour émettre répétitivement des tirs lasers à une fréquence moyenne définissant sensiblement une période de récurrence des impulsions qu'émet le plasma,
et **en ce que** le déplacement de l'objet par rapport au rayonnement est sensiblement continu et d'une vitesse (V) correspondant à une fraction 1/N de largeur de fenêtre (L) divisée par une période de récurrence des impulsions.

7. Procédé selon l'une des revendications précédentes, **caractérisé en ce qu'**il commence sensiblement par les étapes suivantes :
a0) positionner l'objet photosensible à lithographier sous la fenêtre, de manière à ce que seule soit exposée une tranche de zone à insoler ayant une largeur égale à ladite fraction 1/N de largeur de fenêtre,
a1) sélectionner une partie au moins des sources lasers en vue d'exciter la cible génératrice de plasma, et déclencher une impulsion courante vers la zone à insoler,
a2) mesurer la puissance crête de l'impulsion courante de rayonnement extrême ultraviolet effectivement fournie à la zone à insoler de l'objet,
a3) déplacer l'objet par rapport à la fenêtre, d'un incrément de position égal à ladite fraction 1/N de la largeur de fenêtre,
a4) répéter les étapes a1) à a3) tant que la zone à insoler de l'objet, située sous la fenêtre, est plus étroite que la fenêtre, en délivrant des impulsions d'énergies estimées en soustrayant à l'énergie (Wₜₒₜ) à fou rnir pour photograver l'objet la somme des énergies mesurées au cours de n passages successifs par l'étape a2), puis en divisant le résultat de la soustraction par N-n, où n est un entier inférieur au nombre prédéterminé d'impulsions N,
a5) lorsque la zone à insoler de l'objet, située sous la fenêtre, atteint la largeur de la fenêtre, on estime l'énergie exacte restant à fournir pour que la tranche de la zone à photograver recevant sa dernière impulsion obtienne la quantité totale d'énergie (Wₜₒₜ) pour sa photogravure.

8. Dispositif de photolithographie par rayonnement dans l'extrême ultraviolet, comportant :
- une source de rayonnement dans l'extrême ultraviolet comportant au moins deux faisceaux lasers issus de sources lasers pulsées (10-19) émettant chacune un quantum d'énergie (Q) de durée donnée (Δt) au cours d'un tir laser, et capables d'exciter une même région d'une cible (21) apte à émettre un plasma possédant une raie d'émission dans l'extrême ultraviolet,
- une fenêtre d'irradiation (40) de largeur choisie (L), interposée entre la source de rayonnement et l'objet (OBJ), et immobile par rapport à la source de rayonnement (20,22),
- des moyens de déplacement transversal (41) par rapport à la fenêtre, d'un objet à photolithographier (OBJ) ayant une surface plane, orthogonale au rayonnement, et présentant une zone photosensible (PR), ledit déplacement étant choisi de manière qu'entre deux impulsions successives de rayonnement dans l'extrême ultraviolet, le déplacement transversal de l'objet (OBJ) par rapport à la fenêtre soit une fraction 1/N de la largeur de la fenêtre d'irradiation selon la direction du déplacement, de sorte qu'une même bande (Z1,Z2) de ladite zone de l'objet soit exposée à un nombre prédéterminé N d'impulsions successives dans l'extrême ultraviolet,
**caractérisé en ce qu'**il comporte :
- des moyens (31) de mesure de l'énergie surfacique du rayonnement à travers la fenêtre d'irradiation (40),
- des moyens de calcul arrangés, pour une N^{ième} impulsion courante, à délivrer :
* de la somme de l'énergie mesurée du rayonnement dans l'extrême ultraviolet des N-1 dernières impulsions,
* d'une quantité d'énergie restant à fournir par une prochaine N^{ième} impulsion en comparant ladite somme à une dose d'énergie totale prédéterminée (Wₜₒₜ) nécessaire à la photogravure,
* d'un nombre de quanta d'énergie que doivent fournir les sources lasers pour obtenir ladite quantité d'énergie de ladite N^{ième} impulsion,
- des moyens (30) de sélection et de commande en synchronisme d'un nombre choisi de lasers en fonction du nombre de quanta calculé,
et **en ce que** les moyens de déplacement de l'objet à photograver par rapport au rayonnement sont actifs pour déplacer ensuite l'objet d'un incrément équivalent à ladite fraction 1/N de la largeur de la fenêtre.

9. Dispositif selon la revendication 8, **caractérisé en ce que** les moyens de calcul (33) sont agencés pour estimer des dates de tirs lasers pour ajuster l'énergie d'une impulsion à émettre dans l'extrême ultraviolet, et **en ce que** les moyens de commande (Gl, Al, MOA1-MOA10) sont agencés pour commander un décalage temporel des tirs lasers dans un intervalle de temps entre tirs inférieur à ladite durée (Δt) des tirs.

10. Dispositif selon la revendication 9, **caractérisé en ce que** les moyens de commande comportent des modulateurs acousto-optiques (MOA1-MOA10) pour commander chaque source laser à une date choisie, ainsi qu'une alimentation radiofréquence de puissance (AL) pour commander lesdits modulateurs acousto-optiques,
et **en ce que** ladite alimentation et lesdits modulateurs sont capables de fonctionner à une fréquence maximale plus grande, au moins d'un facteur de l'ordre de mille, que la fréquence des impulsions dans l'extrême ultraviolet.

11. Dispositif selon l'une des revendications 9 et 10, **caractérisé en ce que** ledit capteur (31), d'une part, est de durée d'acquisition choisie et les moyens de calcul (33), d'autre part, sont équipés d'un processeur de fréquence de traitement choisie, de sorte que le capteur et les moyens de calcul sont capables de fonctionner conjointement pendant une période inférieure à une période de récurrence des impulsions dans l'extrême ultraviolet.

12. Dispositif selon l'une des revendications 8 à 11, **caractérisé en ce que** ladite cible est un jet de xénon.

13. Dispositif selon l'une des revendications 8 à 11, **caractérisé en ce que** ladite cible est un jet directif de particules comportant des microgouttelettes de xénon et/ou d'eau en brouillard.

14. Dispositif selon l'une des revendications 8 à 13, **caractérisé en ce que** les tirs lasers sont issus de lasers solides impulsionnels fonctionnant en oscillateurs, et pompées par des diodes fonctionnant de façon continue.

15. Dispositif selon l'une des revendications 8 à 14, **caractérisé en ce qu'**une partie fractionnaire du nombre de lasers est représentée par un quantum d'énergie en retard sur le déclenchement synchrone des précédents lasers, et **en ce que** les moyens de sélection sont aptes à générer ces retards en fonction de la valeur de la partie fractionnaire du nombre de lasers, pour générer ladite N^{ième} impulsion courante.

16. Dispositif selon l'une des revendications 8 à 15, **caractérisé en ce que** les moyens de sélection sont agencés pour déclencher un nombre restant de lasers ne contribuant pas à l'émission d'une impulsion dans l'extrême ultraviolet, séparément, de manière à ce que les tirs séparés, issus de ces lasers, ne suffisent pas à l'émission d'une impulsion dans l'extrême ultraviolet.

## Claims

1. An extreme ultraviolet photolithography method in which:
- the radiation (23) carrying out the etching operation includes at least one line in the extreme ultraviolet and consists of N successive current pulses whose energy per unit area through an irradiation window (40) is measured; and
- these radiation pulses are produced by the impact, on a target (21) that is able to emit a plasma possessing an emission line in the extreme ultraviolet, of at least two laser beams output by pulsed laser sources (10-19) chosen from a plurality thereof, each emitting at each triggering a quantum (Q) of energy of given duration (Δt), these laser sources being focused at the same point on the target,
- an object (OBJ) to be lithographed possesses a plane surface, placed orthogonally to the light radiation and having a photosensitive zone (PR), this object being able to be moved (41) transversely to this radiation (23), said displacement being chosen so that, between two successive pulses of extreme ultraviolet radiation, the transverse displacement of the object (OBJ) relative to the window is a fraction 1/N of the width of the irradiation window in the direction of the displacement, in such a way that a same band (Z1, Z2) of said zone of the object is exposed to a predetermined number N of successive pulses in the extreme ultraviolet,
this method comprising the following iterative steps, stated for an Nth pulse of a given band (Z1, Z2):
a) integration of the energy per unit area of extreme ultraviolet radiation that has passed through the irradiation window during the N-1 last pulses;
b) during the time interval separating two successive radiation pulses, translation of the photosensitive object through a distance equal to a fraction 1/N of the width (L) of the irradiation window along the axis of this translation;
c) subtraction of the integral obtained in step a) from the quantity of energy (Wₜₒₜ) needed for the photoetching process;
d) determination of the quantity of energy remaining to be provided in order to reach this quantity of energy (Wₜₒₜ);
e) calculation of the number of pulse quanta remaining to be generated for an Nth pulse;
f) determination of the corresponding number of laser sources to be fired and selection of laser sources whose number is equal to the integer part of this number; and
g) synchronous triggering of the lasers selected at step f),
these steps a) to g) being repeated for the next band.

2. The method as claimed in claim 1, in which the number of laser sources calculated at step f) is fractional and the quantity of energy less than one quantum, associated with this fractional part of the number of lasers, is provided by a laser source capable of delivering the quantum of energy common to the other laser sources and is triggered with a delay, of less than the duration (Δt) of a quantum, relative to the instant of synchronous triggering of the other laser sources that deliver the integer part of the number of quanta of the same current pulse.

3. The method as claimed in claim 1, in which the number of laser sources calculated at step f) is fractional and the quantity of energy less than one quantum, associated with this fractional part of the number of lasers, is provided by a laser source capable of delivering an amount of energy of less than one quantum and triggered with a delay, of less than the duration (Δt) of a quantum, relative to the instant of synchronous triggering of the other laser sources that deliver the integer part of the number of quanta of the same current pulse.

4. The method as claimed in either of claims 2 and 3, in which the number of laser sources calculated at step f) is fractional and the quantity of energy less than one quantum, associated with this fractional part of the number of lasers, is provided by several laser sources of which:
- the first is triggered with a delay of (1-k₁)Δt, where 0 < k₁ < 1, after the instant of triggering of the synchronous lasers that represent the integer part of the number of lasers;
- the second is triggered with a delay of (1-k₂)Δt, where k₁ < k₂ < 1, after the instant of triggering of the synchronous lasers that represent the integer part of the number of lasers;
- and so on, the qth being triggered with a delay of (1-k_{q})Δt, where 0 < kq < 1, after the instant of triggering of the synchronous lasers that represent the integer part of the number of lasers; and, furthermore
- the sum of these delays is less than the duration Δt of a quantum.

5. The method as claimed in one of claims 2 to 4, **characterized in that** the following are triggered:
- at least a first laser shot at a predetermined instant (t₁₁), and
- one or more successive laser shots at respective instants chosen to adjust the energy of an extreme ultraviolet pulse to be emitted, these respective instants being distributed within a time interval shorter than said duration (Δt) of the shots.

6. The method as claimed in one of the preceding claims, **characterized in that** the laser sources are actuated so as to emit laser shots repetitively with a mean frequency substantially defining a repetition period of the pulses that emit the plasma and **in that** the displacement of the object relative to the radiation is substantially continuous with a speed (V) corresponding to a fraction 1/N of the width of the window (L) divided by a pulse repetition period.

7. The method as claimed in one of the preceding claims, **characterized in that** it commences substantially with the following steps:
a0) the photosensitive object to be lithographed is positioned beneath the window so that only a zone slice to be irradiated that has a width equal to said fraction 1/N of the window width is exposed;
a1) at least some of the laser sources are selected so as to excite the plasma-generating target, and a current pulse in the zone to be irradiated is triggered;
a2) the peak power of the current extreme ultraviolet pulse actually delivered to the zone of the object to be irradiated is measured;
a3) the object is displaced relative to the window by a position increment equal to said fraction 1/N of the window width;
a4) steps a1) to a3) are repeated as long as the zone of the object to be irradiated, located beneath the window, is narrower than the window, by delivering pulses with energies estimated by subtracting, from the energy (Wₜₒₜ) to be delivered for photoetching the object, the sum of the energies measured during the n successive passes through step a2), and then by dividing the result of the subtraction by N-n, where n is an integer smaller than the predetermined number of pulses N; and
a5) when the zone of the object to be irradiated, located beneath the window, reaches the width of the window, the precise amount of energy remaining to be provided is estimated, so that the slice of the zone to be photoetched receiving its final pulse receives the total quantity of energy (Wₜₒₜ) for photoetching it.

8. An extreme ultraviolet photolithography device comprising:
- a source of extreme ultraviolet radiation, comprising at least two laser beams output by pulsed laser sources (10-19), each emitting a quantum of energy (Q) of given duration (Δt) during a laser shot and capable of exciting one and the same region of a target (21) that is able to emit a plasma possessing an emission line in the extreme ultraviolet;
- an irradiation window (40) of chosen width (L), interposed between the radiation source and the object (OBJ) and stationary relative to the radiation source (20, 22); and
- means (41) for the transverse displacement, relative to the window, of an object (OBJ) to be photolithographed that has a plane surface, orthogonal to the radiation, and has a photosensitive zone (PR), said displacement being chosen so that, between two successive pulses of extreme ultraviolet radiation, the transverse displacement of the object (OBJ) relative to the window is a fraction 1/N of the width of the irradiation window in the direction of the displacement, in such a way that any one band (Z1, Z2) of said zone of the object is exposed to a predetermined number N of successive pulses in the extreme ultraviolet,
**characterized in that** it includes:
- means (31) for measuring the energy per unit area of the radiation through the irradiation window (40);
- adapted means for calculating, for the current Nth pulse to be delivered:
* the sum of the measured energy of the extreme ultraviolet radiation of the N-1 last pulses,
* the quantity of energy remaining to be delivered by the next Nth pulse, by comparing said sum with a predetermined total energy dose (Wₜₒₜ) needed for the photoetching, and
* the number of quanta of energy that the laser sources have to deliver in order to obtain said quantity of energy of said Nth pulse; and
- means (30) for selecting and controlling, synchronously, a chosen number of lasers according to the calculated number of quanta,
and **in that** the means for displacing the object to be photoetched relative to the radiation are active, so as subsequently to displace the object by an increment equivalent to said fraction 1/N of the width of the window.

9. The device as claimed in claim 8, **characterized in that** the calculation means (33) are designed to estimate instants of laser firings in order to adjust the energy of a pulse to be emitted in the extreme ultraviolet and **in that** the control means (PG, PS, AOM1-AOM10) are designed to introduce a time delay in the laser firings within a time interval between shots that is shorter than said duration (Δt) of the shots.

10. The device as claimed in claim 9, **characterized in that** the control means comprise acoustooptic modulators (AOM1-AOM10), for actuating each laser source at a chosen instant, and a radiofrequency power supply (PS) for actuating said acoustooptic modulators and **in that** said power supply and said modulators are capable of operating at a maximum frequency greater, by at least a factor of the order of a thousand, than the frequency of the extreme ultraviolet pulses.

11. The device as claimed in either of claims 9 and 10, **characterized in that** said sensor (31), on the one hand, has a chosen acquisition time and the calculating means (33), on the other hand, are equipped with a processor having a chosen processing frequency, in such a way that the sensor and the calculating means are capable of operating jointly over a period shorter than the extreme ultraviolet pulse repetition period.

12. The device as claimed in one of claims 8 to 11, **characterized in that** said target is a xenon jet.

13. The device as claimed in one of claims 8 to 11, **characterized in that** said target is a directed jet of particles comprising xenon and/or water microdroplets in the form of a mist.

14. The device as claimed in one of claims 8 to 13, **characterized in that** the laser shots are output by pulsed solid-state lasers operating as oscillators and pumped by continuously operating diodes.

15. The device as claimed in one of claims 8 to 14, **characterized in that** the fractional part of the number of lasers is represented by a quantum of energy delayed with respect to the synchronous triggering of the previous lasers and **in that** the selection means are capable of generating these delays according to the magnitude of the fractional part of the number of lasers, in order to generate said current Nth pulse.

16. The device as claimed in one of claims 8 to 15, **characterized in that** the selection means are designed to trigger a remaining number of lasers not contributing to the emission of an extreme ultraviolet pulse, separately, so that the separate shots, output by these lasers, are not sufficient to emit an extreme ultraviolet pulse.

## Patentansprüche

1. Fotolithographie-Verfahren durch Extremultraviolett-Strahlung, wobei:
- die Strahlung (23), die die Gravur bewirkt, mindestens einen Strahl im Extremultraviolett-Bereich umfasst und aus N laufenden, aufeinander folgenden Impulsen gebildet ist, deren Oberflächenenergie durch ein Bestrahlungsfenster (40) gemessen wird,
- diese Strahlungsimpulse durch das Auftreffen von mindestens zwei Laserstrahlenbündeln auf einem Ziel (21) erzeugt werden, welches geeignet ist, ein Plasma auszusenden, das eine Emissionslinie im Extremultraviolett-Bereich hat, wobei diese Laserstrahlenbündel aus Impulslaserquellen (10-19) stammen, die aus einer Vielzahl gewählt werden und jeweils bei jeder Auslösung ein Energiequantum (Q) von gegebener Dauer (Δt) aussenden, wobei diese Laserquellen auf die gleiche Stelle des Ziels fokussiert werden.
- ein zu lithographierendes Objekt (OBJ) eine ebene Oberfläche aufweist, die im rechten Winkel zu der Lichtstrahlung angeordnet ist und eine fotoempfindliche Zone (PR) aufweist, wobei dieses Objekt geeignet ist, sich quer zu dieser Strahlung (23) zu verschieben, wobei dieses Verschieben dergestalt gewählt wird, dass zwischen zwei aufeinander folgenden Extremultraviolett-Strahlungsimpulsen das Verschieben des Objekts (OBJ) in Querrichtung, bezogen auf das Fenster, einen Bruchteil 1/N der Breite des Bestrahlungsfensters in der Richtung der Verschiebung beträgt, so dass ein und derselbe Streifen (Z1, Z2) dieser Zone des Objekts einer vorbestimmten Anzahl N von aufeinander folgenden Extremultraviolett-Impulsen ausgesetzt wird, wobei dieses Verfahren die folgenden sich wiederholenden Verfahrensschritte umfasst, die für den N-ten Impuls eines gegebenen Streifens (Z1, Z2)ausgedrückt sind:
a) Integration der Oberflächenenergie der Extremultraviolett-Strahlung, die bei den letzten N-1 Impulsen durch das Bestrahlungsfenster gelangt ist,
b) Vorschubbewegung des fotoempfindlichen Objekts während des Zeitraums zwischen zwei aufeinander folgenden Bestrahlungsimpulsen um eine Strecke, die gleich einem Bruchteil 1/N der Breite (L) des Bestrahlungsfensters auf der Achse dieser Vorschubbewegung ist,
c) Subtraktion des in Verfahrensschritt a) erzielten Integrals von der Energiemenge (Wₜₒₜ), die für den Fotogravurprozess erforderlich ist,
d) Bestimmung der Energiemenge, die noch zugeführt werden muss, um diese Energiemenge (Wₜₒₜ) zu erreichen,
e) Berechnung der Anzahl von Impulsquanten, die noch zu erzeugen sind, um einen N-ten Impuls zu erzeugen,
f) Bestimmung einer entsprechenden Anzahl von Laserquellen, die einzuschalten sind, sodann Auswahl von Laserquellen in gleicher Anzahl wie der gesamte Teil dieser Anzahl,
g) Synchrones Auslösen der in Verfahrensschritt f) gewählten Laser, und Wiederholung der Schritte a) bis g) für den nächsten Streifen.

2. Verfahren nach Anspruch 1, bei dem die Zahl von Laserquellen, die in Schritt f) berechnet werden, einen unechten Bruch bildet und die Energiemenge, die unterhalb eines Quantums liegt, das mit diesem unechten Bruch der Zahl von Lasern verbunden ist, durch eine Laserquelle zugeführt wird, die geeignet ist, das den anderen Laserquellen gemeinsame Energiequantum abzugeben, und mit einer Verzögerung ausgelöst wird, die geringer ist als die Dauer (Δt) eines Quantums, bezogen auf den Zeitpunkt der synchronen Auslösung der anderen Laserquellen, die den gesamten Teil der Quantenanzahl des gleichen laufenden Impulses abgeben.

3. Verfahren nach Anspruch 1, bei dem die Zahl von Laserquellen, die in Schritt f) berechnet werden, einen unechten Bruch bildet und die Energiemenge, die unterhalb eines Quantums liegt, das mit diesem unechten Bruch der Zahl von Lasern verbunden ist, durch eine Laserquelle zugeführt wird, die geeignet ist, eine Energie abzugeben, die geringer ist als ein Quantum, und mit einer Verzögerung ausgelöst wird, die geringer ist als die Dauer (Δt) eines Quantums, bezogen auf den Zeitpunkt des synchronen Auslösens der anderen Laserquellen, die den gesamten Teil der Quantenanzahl des gleichen laufenden Impulses abgeben.

4. Verfahren nach einem der Ansprüche 2 oder 3, bei dem die Zahl von Laserquellen, die in Schritt f) berechnet werden, einen unechten Bruch bildet und die Energiemenge, die unterhalb eines Quantums liegt, das mit diesem unechten Bruch der Zahl von Lasern verbunden ist, durch mehrere Laserquellen zugeführt wird, von denen
- die erste mit einer Verzögerung (1-k₁)Δt (wobei 0<k₁<1) nach dem Zeitpunkt des Auslösens der synchronen Laser, die den gesamten Teil der Anzahl der Laser darstellen, ausgelöst wird,
- die zweite mit einer Verzögerung (1-k₂) Δt (wobei k₁<k₂<1) nach dem Zeitpunkt des Auslösens der synchronen Laser, die den gesamten Teil der Anzahl der Laser darstellen, ausgelöst wird, und so fort, wobei
- die q-te mit einer Verzögerung (1-k_{q}) Δt (wobei 0<k_{q}<1) nach dem Zeitpunkt des Auslösens der synchronen Laser, die den gesamten Teil der Anzahl der Laser darstellen, ausgelöst wird, und
- ferner die Summe dieser Verzögerungen kleiner ist als die Dauer eines Quantums Δt.

5. Verfahren nach einem der Ansprüche 2 bis 4,
**dadurch gekennzeichnet,**
**dass** das Auslösen folgendermaßen gesteuert wird:
- mindestens ein erster Laserschuss zu einem vorbestimmten Zeitpunkt (t₁₁), und
- ein oder mehrere aufeinander folgende Laserschüsse zu jeweils gewählten Zeitpunkten, um die Energie eines auszusendenden Extremultraviolett-Impulses einzustellen, wobei diese jeweiligen Zeitpunkte innerhalb eines Zeitintervalls verteilt liegen, das kleiner ist als die genannte Dauer der Schüsse Δt.

6. Verfahren nach einem der vorherigen Ansprüche,
**dadurch gekennzeichnet,**
**dass** die Laserquellen dahingehend gesteuert werden, um wiederholt Laserschüsse mit einer mittleren Frequenz abzugeben, die im Wesentlichen eine Impulsfolge-Periode, die das Plasma aussendet, bestimmt, und dass das Verschieben des Objekts gegenüber der Strahlung im Wesentlichen kontinuierlich und mit einer Geschwindigkeit (V) erfolgt, die einem Bruchteil 1/N der Fensterbreite (L), geteilt durch eine Impulsfolge-Periode, entspricht.

7. Verfahren nach einem der vorherigen Ansprüche,
**dadurch gekennzeichnet,**
**dass** es im Wesentlichen mit den folgenden Schritten beginnt:
a0) das zu lithographierende fotoempfindliche Objekt (OBJ) wird dergestalt unter dem Fenster positioniert, dass nur eine Scheibe der zu bestrahlenden Zone mit einer Breite, die gleich dem genannten Bruchteil 1/N der Fensterbreite ist, der Strahlung ausgesetzt wird.
a1) mindestens ein Teil der Laserquellen wird ausgewählt, um das plasmaerzeugende Ziel zu erregen, und es wird ein laufender Impuls in Richtung der zu bestrahlenden Zone ausgelöst,
a2) es wird die Spitzenleistung des laufenden Extremultraviolett-Strahlungsimpulses gemessen, die tatsächlich auf die zu bestrahlende Zone des Objekts abgegeben wird,
a3) das Objekt wird gegenüber dem Fenster um ein Positionsinkrement verschoben, welches gleich diesem Bruchteil 1/N der Fensterbreite ist,
a4) die Schritte a1) bis a3) werden wiederholt, so lange die zu bestrahlende Zone des Objekts, die sich unter dem Fenster befindet, schmaler ist als das Fenster, indem berechnete Energieimpulse abgegeben werden, wobei von der Energie (Wₜₒₜ), die zum Fotogravieren des Objekts abzugeben ist, die Summe der mittels Schritt a2) im Verlauf von n aufeinanderfolgenden Durchgängen gemessenen Energien subtrahiert wird und sodann das Ergebnis der Subtraktion durch N-n dividiert wird, wobei n eine ganze Zahl ist, die kleiner als die vorbestimmte Zahl von Impulsen N ist,
a5) wenn die zu bestrahlende Zone des Objekts, die sich unter dem Fenster befindet, die Breite des Fensters erreicht, wird die exakte Energie ausgerechnet, die noch abzugeben bleibt, damit die Scheibe der zu fotogravierenden Zone, die ihren letzten Impuls empfängt, die Gesamtenergiemenge (Wₜₒₜ) für ihre Fotogravur erhält.

8. Vorrichtung zur Fotolithographie durch Extremultraviolett-Strahlung, die aufweist:
- eine Extremultraviolett-Strahlungsquelle mit mindestens zwei Laserstrahlenbündeln, die von Impulslaserquellen (10-19) ausgehen, die jeweils bei einem Laserschuss ein Energiequantum (Q) von gegebener Dauer (Δt) aussenden, und geeignet sind, einen und den selben Bereich eines Ziels (21) zu erregen, das geeignet ist, ein Plasma auszusenden, das eine Emissionslinie im Extremultraviolett-Bereich hat,
- ein Bestrahlungsfenster (40) von ausgewählter Breite (L), das zwischen der Strahlungsquelle und dem Objekt (OBJ) angeordnet ist und gegenüber der Strahlungsquelle (20, 22) unbeweglich ist,
- Mittel zum Querverschieben (41) eines zu fotolithographierenden Objekts (OBJ) gegenüber dem Fenster, wobei dieses Objekt eine ebene, im rechten Winkel zur Strahlung angeordnete Oberfläche hat und eine fotoempfindliche Zone (PR) aufweist, wobei dieses Verschieben dergestalt gewählt wird, dass die Querverschiebung des Objekts (OBJ) gegenüber dem Fenster zwischen zwei aufeinander folgenden Extremultraviolett-Strahlungsimpulsen einen Bruchteil 1/N der Bestrahlungsfensterbreite in der Richtung der Verschiebung beträgt, so dass ein und derselbe Streifen (Z1, Z2) dieser Zone des Objekts einer vorbestimmten Anzahl N von aufeinander folgenden Extremultraviolett-Impulsen ausgesetzt wird,
**dadurch gekennzeichnet,**
**dass** sie aufweist:
- Mittel (31) zum Messen der Oberflächenenergie der Strahlung durch das Bestrahlungsfenster (40),
- Mittel, die vorgesehen sind, um für einen N-ten abzugebenden Impuls zu berechnen:
- die Summe der gemessenen Energie der Extremultraviolett-Strahlung der N-1 letzten Impulse,
- eine Energiemenge, die durch einen nächsten, N-ten Impuls noch abgegeben werden muss, indem diese Summe mit einer vorbestimmten Gesamtenergiedosis (Wₜₒₜ), die für den Fotogravurprozess erforderlich ist, verglichen wird,
- eine Anzahl von Energiequanten, die die Laserquellen abgeben müssen, um diese Energiemenge dieses N-ten Impulses zu erreichen,
- Mittel (30) zum Auswählen und Synchronsteuern einer gewählten Anzahl von Lasern in Abhängigkeit von der berechneten Anzahl von Quanta,
und **dass** die Mittel zum Verschieben des zu fotogravierenden Objekts gegenüber der Strahlung aktiv sind, um das Objekt sodann um ein Inkrement zu verschieben, das gleichwertig mit dem genannten Bruchteil 1/N der Fensterbreite ist.

9. Vorrichtung nach Anspruch 8,
**dadurch gekennzeichnet,**
**dass** die Rechenmittel (33) dazu geschaffen sind, Zeitpunkte von Laserschüssen auszurechnen, um die Energie eines Impulses, der im Extremultraviolett-Bereich abzugeben ist, einzustellen, und dass die Steuermittel (Gl, Al, MOA1-MOA10) dazu geschaffen sind, eine zeitliche Versetzung der Laserschüsse in einem Zeitintervall zwischen Schüssen, das kleiner ist als die genannte Dauer (Δt) der Schüsse, zu steuern.

10. Vorrichtung nach Anspruch 9,
**dadurch gekennzeichnet,**
**dass** die Steuermittel akustisch-optische Modulatoren (MOA1-MOA10) umfassen, um jede Laserquelle zu einem gewählten Zeitpunkt zu steuern, sowie eine leistungsstarke Hochfrequenzversorgung (AL) umfassen, um diese akustisch-optischen Modulatoren zu steuern,
und **dass** diese Versorgung und diese Modulatoren geeignet sind, mit einer Maximalfrequenz zu arbeiten, die mindestens mit einem Faktor in der Größenordnung von Tausend höher ist als die Frequenz der Impulse im Extremultraviolett-Bereich.

11. Vorrichtung nach einem der Ansprüche 9 und 10,
**dadurch gekennzeichnet,**
**dass** einerseits der Sensor (31) eine gewählte Erfassungszeitdauer aufweist und andererseits die Rechenmittel (33) mit einem Prozessor mit gewählter Verarbeitungsfrequenz ausgerüstet sind, so dass der Sensor und die Rechenmittel geeignet sind, während einer Periode, die kleiner ist als eine Extremultraviolett-Impulsfolge-Periode, zusammenzuwirken.

12. Vorrichtung nach einem der Ansprüche 8 bis 11,
**dadurch gekennzeichnet,**
**dass** das genannte Ziel ein Xenon-Strahl ist.

13. Vorrichtung nach einem der Ansprüche 8 bis 11,
**dadurch gekennzeichnet,**
**dass** das genannte Ziel ein Partikelleitstrahl ist, der Mikrotröpfchen von vernebeltem Xenon und/oder Wasser enthält.

14. Vorrichtung nach einem der Ansprüche 8 bis 13,
**dadurch gekennzeichnet,**
**dass** die Laserschüsse aus festen Impulslasern stammen, die oszillierend arbeiten, und durch Dioden, die kontinuierlich arbeiten, gepumpt werden.

15. Vorrichtung nach einem der Ansprüche 8 bis 14,
**dadurch gekennzeichnet,**
**dass** ein Bruchteil der Anzahl der Laser durch ein Energiequantum dargestellt wird, das gegenüber der synchronen Auslösung der vorherigen Laser verzögert wird, und dass die Auswahlmittel geeignet sind, diese Verzögerungen in Abhängigkeit von dem Wert des Bruchteils der Anzahl der Laser zu erzeugen, um den genannten N-ten laufenden Impuls zu erzeugen.

16. Vorrichtung nach einem der Ansprüche 8 bis 15,
**dadurch gekennzeichnet,**
**dass** die Auswahlmittel dazu geschaffen sind, eine restliche Anzahl von Lasern, die nicht zur Abgabe eines Extremultraviolett-Impulses beitragen, getrennt auszulösen, so dass die getrennten Schüsse, die aus diesen Lasern kommen, nicht zur Abgabe eines Extremultraviolett-Impulses ausreichen.
